Europäisches Patentamt

European Patent Office

Office européen des brevets

(11) Publication number: **0 103 468**
**A2**

(12) **EUROPEAN PATENT APPLICATION**

(21) Application number: **83305274.9**

(22) Date of filing: **09.09.83**

(51) Int. Cl.³: **H 03 K 13/02**

(30) Priority: **13.09.82 US 417238**

(43) Date of publication of application: **21.03.84**
**Bulletin 84/12**

(84) Designated Contracting States: **AT BE CH DE FR GB IT LI NL SE**

(71) Applicant: **DEERE & COMPANY, 1 John Deere Road, Moline Illinois 61265 (US)**

(72) Inventor: **Nichols, Boyd Morton, 1812 Hilton Drive, Cedar Falls Iowa 50613 (US)**

(74) Representative: **Pears, David Ashley et al, REDDIE & GROSE 16 Theobalds Road, London WC1X 8PL (GB)**

(54) Analog to digital conversion system.

㉗ Sensors (10, 12, 14, 16) provide analog signals having different zero offsets and spans. The signals are applied by way of a multiplexer (18) to a single analog-to-digital converter (22). In order that all digital outputs shall have the same span, digital offset and span values for all of the sensors are stored in a non-volatile memory (40). A microprocessor control unit (30) controls the multiplexer (18) and simultaneously applies corresponding offset and span signals to two digital-to-analog converts (34, 36) which apply corresponding offset and reference voltages to the analog-to-digital converter (22).

ACTORUM AG

- 1 -

ANALOG TO DIGITAL CONVERSION SYSTEM

The present invention relates to an analog-to-digital signal conversion system.

It is not unusual for a digital control system to include a plurality of physical parameter sensors. In such a control system, the input range of the analog-to-digital converter (ADC) must cover the sensor with the widest voltage variation. If other sensors are connected to the same ADC, then the resolution with which these other sensors can be read is diminished by the ratio of the sensor's full output voltage variation to the ADC input voltage range. One solution has been to make span and offset adjustments in the digital domain after an analog-sensed value has been converted to digital. This wastes resolution and uses up valuable microprocessor time in unnecessary calculations. In some cases, it may even be necessary to utilize a more expensive 10 or 12-bit ADC to obtain at least an 8-bit resolution for all sensed values.

An object of the present invention is to provide efficient analog-to-digital conversion of a plurality of sensed values.

The system according to the present invention is defined in claim 1 below.

The invention will be described in more detail by way of example, with reference to the accompanying drawings, in which:

Fig 1 is a schematic block diagram of the components of an embodiment of the present invention; and

Fig 2 is a simplified flow chart of the conversion algorithm used with the apparatus shown in Fig 1.

A control system may include a plurality of parameter sensors 10, 12, 14 and 16 for measuring such physical parameters such as pressure, temperature, force, displacement, etc. The analog output signals of sensors 10-16 may vary in voltage span or range and offset. For example, sensor 10 may have an output voltage range of 2.0 to 4.0 volts; sensor 12 a range of 3.5 to 4.5 volts; sensor 14 a range of 0.5 to 1.5 volts and sensor 16 a range of 0 to 5.0 volts.

The outputs of the sensors 10-16 are coupled to respective inputs of a conventional analog multiplexer 18 which includes address control inputs 20. The output of the multiplexer 18 is coupled to the analog input of an analog-to-digital converter (ADC) 22. Preferably the ADC is a conventional successive approximation-type, such as National Semiconductor Part No ADC-0801, which includes a resistor ladder (not shown). The ADC outputs 28 communicate a digital 8-bit parallel output signals to a data processing unit 30, such as a microprocessor.

The data processing unit 30 operates upon the data received from the ADC 22, according to any desired control algorithm which forms no part of the present invention. The data processing unit 30 generates address control signals which are applied to the multiplexer 18 via lines 32. The data processor 30 also generates digital calibration control signals which are applied to conventional digital-to-analog converters (DAC) 34 and 36. DACs 34 and 36 convert the digital calibration signals to analog offset and span calibration signals which are applied to the IN- and RED terminals respectively of the ADC 22.

The microprocessor 30 is also coupled with a non-volatile memory (NOVRAM) 40 and a grounded switch 42 which are used in connection with a calibration scheme which will be described next.

An automatic calibration scheme may be implemented in the following manner. First, switch 42 is opened to inform the microprocessor 30 that the operator is performing a calibration. DAC 34 is then set to apply 0 volts to the IN- input of ADC 22 and DAC 36 is set to apply its maximum output, 5 volts, for example, to the REF input of ADC 22. Each sensor (10-16) is then exercised over its full operating range and the microprocessor 30 is made to store the minimum and maximum values for each sensor. The switch 42 is then closed after which the sensor minimum values are stored in the non-volatile memory 40 for use as the offset value which is applied to the IN- input of ADC 22 via DAC 34 every time the corresponding sensor is read. The microprocessor 30 then subtracts the minimum value from the maximum value for each sensor and stores the resultant difference value in the non-volatile memory 40 as a "span" value. Then, each time a particular sensor output is digitized, the corresponding span value is applied to the REF input of ADC 22 via DAC 36.

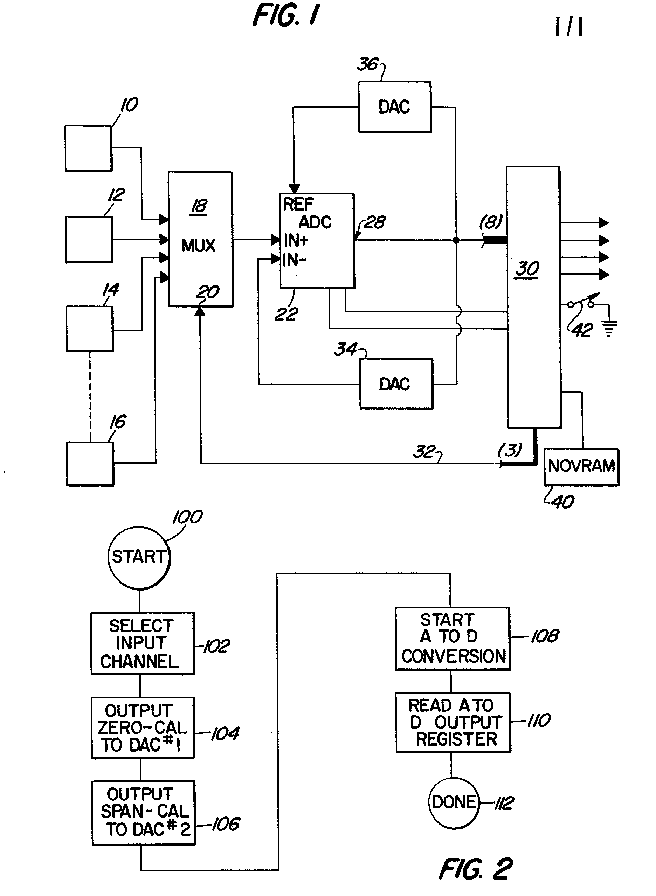

Then, during execution of some control algorithm by the data processing unit 30, a conversion routine is executed whenever a value from one of the sensors 10-16 is to be read into the data processing unit 30 via ADC 22. This conversion routine will now be described with reference to the flow chart shown in Fig 2.

The conversion routine begins at step 100. Then, at step 102, the data processing unit 30 sends an address signal to the multiplexer 18 so that the analog voltage from the selected sensor will be applied to the IN+ input of ADC 22. Then, in step 104, the offset digital calibration value (stored in memory) is applied to DAC 34. Then, in step 106, the span digital calibration value (stored in memory) is applied to DAC 36. Thus, the analog voltage equivalents of the stored offset and span values will be applied to the IN- and REF inputs of ADC 22 via DACs 34 and 36.

At step 108, the analog value applied to the IN+ input of ADC 22 is converted with full 8-bit resolution to a corresponding digital value which is contained in an output register (not shown) in the ADC 22. The conversion is in each case normalized in accordance with the offset value and the span value so that the digital range for every parameter is the same, e.g. 0 to 11111111 in the case of an unsigned 8-bit system. This digital value is then read by the data processor unit 30. This conversion routine is completed at step 112 and is repeated for each of sensors 10-16 with different offset and span calibration values chosen for each different sensor. In this manner, the digital value will be obtained with the full resolution capability of the ADC 22, regardless of the different span and offsets of the analog output voltages provided by the different sensors.

- 4 -

<u>CLAIMS</u>

1.    An analog-to-digital conversion system characterised by the combination of a plurality of parameter sensors (10 .... 16), an analog multiplexer (18) having a plurality of inputs coupled to respective ones of the parameter sensors, and an output coupled to an analog-to-digital converter (22) having an offset signal input (IN-) and a span signal input (REF), a first digital-to-analog converter (34) with an output coupled to the offset signal input, a second digital-to-analog converter (36) with an output coupled to the span signal input, and a control unit (30) coupled to the multiplexer, to the analog-to-digital converter and to the first and second digital-to-analog converters, the control unit including storage means (40) for storing digital offset and span reference values corresponding to each of the plurality of parameter sensors, and being arranged when coupling any sensor to the analog-to-digital converter via the multiplexer to apply the corresponding digital reference values to the first and second digital-to-analog converters.

2.    A conversion system according to claim 1, characterised in that the storage means (40) comprises a non-volatile memory.

3.    A conversion system according to claim 1, characterised in that the control unit (30) comprises a microprocessor, and the storage means (40) comprises a non-volatile memory coupled to the microprocessor.

4.    A method of calibrating an analog-to-digital conversion system according to claim 1, 2 or 3, characterised by the steps of:

    a)    setting the first digital-to-analog converter (34) to its minimum output condition and setting the second digital-to-analog converter (36) to its maximum output condition;

    b)    exercising each parameter sensor (10 ..... 16) over its full operating range to generate minimum and maximum output values for each parameter sensor;

- 5 -

c)    storing the minimum output values;

d)    subtracting each minimum output value from its corresponding maximum value to obtain a span value for each parameter sensor; and

e)    storing each of the span values.

0103468

1/1

**FIG. 1**

**FIG. 2**